# DEMANDE DE BREVET EUROPEEN

(11) **EP 4 645 724 A1**
(43) Date de publication de la demande: **05.11.2025**
(21) Numéro de dépôt: 25172600.6
(22) Date de dépôt: 25.04.2025
(51) Int. Cl.: H04L 1/00, H03M 13/23, H03M 13/41

(54) **DÉCODAGE VITERBI OPTIMISÉ POUR COMMUNICATIONS ULB**

(30) Priorité: 02.05.2024 FR 2404623
(71) Demandeur: STMicroelectronics International N.V., 1228 Plan-les-Ouates, Geneva (CH)
(72) Inventeur: GRAFFOULIERE, Philippe, 38340 VOREPPE (FR)
(74) Mandataire: Casalonga

(57) **Abrégé**

Un récepteur (115) reçoit des trains d'impulsions (r₀, r₁) codant une pluralité de bits (b) à l'aide d'un code convolutif {3, 2, 5} dont les bits systématique g₀ et de parité g₁ sont mappés en deux trains binaires (21, 22) dépendants respectivement de g₀^g₁ et g₁. Constatant que le codage convolutif et le mappage conduisent à moduler (b.z-1^b^b.z+1, b.z-1^b.z+1, b.z-1^b.z+1), un démodulateur démodule les paires de trains d'impulsions reçus (r₀, r₁) en des paires respectives de valeurs LLR (b₀, b₁) et un décodeur de Viterbi construit sur un code convolutif {3, 7, 5} décode chaque paire de valeurs LLR en un bit décodé (d). Un décodage optimal est ainsi obtenu, présentant notamment un gain évalué à 1,8 dB (en taux d'erreurs) sans complexité additionnelle.

## Description

### DOMAINE TECHNIQUE

Des modes de réalisation et de mise en œuvre concernent le domaine de la transmission de données et plus particulièrement celui du décodage de données à l'aide d'un décodeur de Viterbi.

### CONTEXTE TECHNIQUE

La transmission de données en Ultra Large Bande ULB utilise des impulsions de radiofréquence très courtes (souvent inférieure à la nanoseconde), sur une grande bande passante de l'ordre de 500 MHz ou plus. Les communications ULB (ou UWB pour « ultra wideband » en langue anglosaxonne) opèrent à des fréquences comprises entre 3,1GHz et 10,6GHz, par exemple dans une première bande entre 3,1GHz et 4,8GHz ou une deuxième bande entre 6GHz et 8,5GHz.

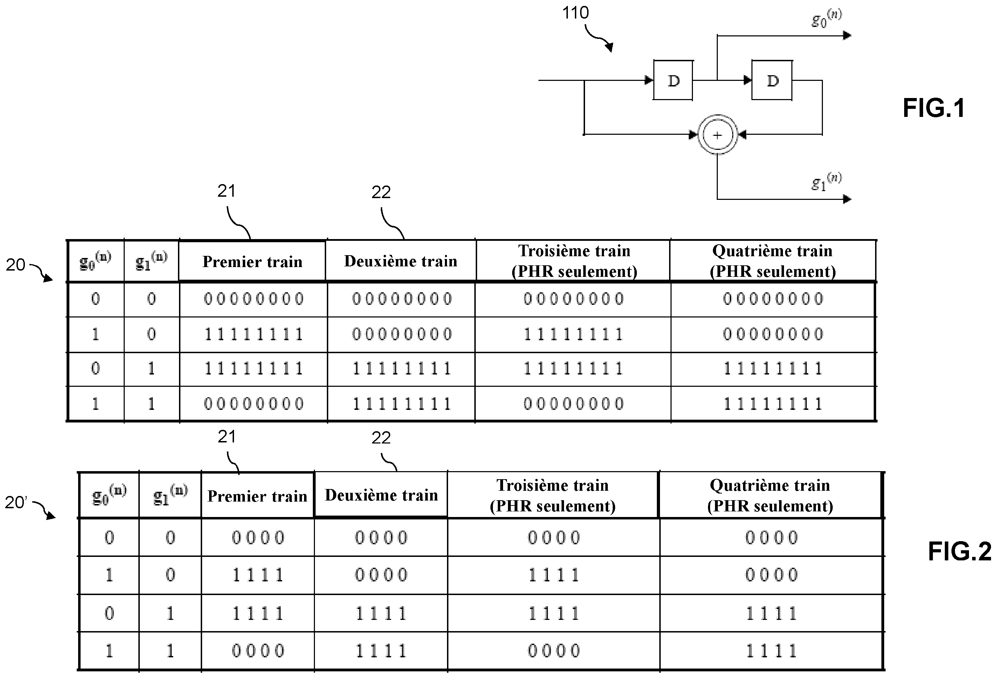

Traditionnellement, les bits à transmettre (de l'entête PHY, noté PHR, et de la charge utile PSDU) sont codés à l'aide du codeur convolutif systématique 110 de la Figure 1. La Figure illustre un codeur convolutif systématique conforme à la norme IEEE Std 802.15.4z-2020 (nom commercial), par exemple dans le mode dit HPRF (pour « Higher Pulse Repetition Frequency »). Ce codeur convolutif est dit {3, 2, 5} en raison de sa longueur de contrainte K=3 et de ses polynômes générateurs g₀ = [010] (soit 2) et g₁ = [101] (soit 5). Il présente un rendement R de 1/2.

En pratique, chaque bit à transmettre est transmis à l'aide de train d'impulsions modulées en BPSK (modulation par changement de phase binaire) avec une fréquence de répétition de 124,8 ou 249,6 MHz. La Figure 2 définit par exemple les trains binaires correspondant aux impulsions à émettre, en fonction du bit systématique g₀ et du bit de parité g₁ obtenus en sortie du codeur convolutif. La table 20 du haut définit les trains binaires pour une fréquences de répétition FRP de 124,8 MHz, et celle 20' du bas pour une PRF de 249,6 MHz.

Ces tables montrent que le premier train binaire ne dépend pas seulement g₀ mais également de g₁, alors que le deuxième train binaire à émettre dépend uniquement de g₁. Plus précisément, le premier train binaire est fonction de g₀^g₁ (^ étant l'opérateur OU EXCLUSIF). En d'autres termes, ce n'est pas (g₀, g₁) qui est modulé, mais (g₀^g₁, g₁).

Côté récepteur, le décodage consiste dès lors à opérer un mappage inverse pour retrouver le bit systématique, noté b₀, à partir des deux trains d'impulsions reçus (r₀, r₁) : b₀=ABS(r₁-r₀)-ABS(r₁+r₀), le bit de parité, noté b₁, étant obtenu directement du deuxième train d'impulsions reçus : b₁=r₁. Puis, un décodeur de Viterbi construit sur le code convolutif systématique {3, 2, 5} de l'encodeur est utilisé pour décoder chaque bit transmis à partir des paires (b₀, b₁) décodées.

Il est admis que ce décodage n'est pas optimal.

D'une part, la distance de décodage du bit systématique b₁ est moitié moindre de celle du bit de parité b₁. Le taux d'erreur sur b₁ est donc plus élevé que sur b₁.

D'autre part, le décodage souple (ou « soft-decision decoding ») d'un algorithme de Viterbi serait sous-exploité en raison du décodage ferme (ou « hard-decision decoding ») du mappage inverse.

Il existe par conséquent le besoin d'un décodage amélioré de tels signaux formés de trains d'impulsions codant une pluralité de bits à l'aide du code convolutif {3, 2, 5}, et dont les bits systématique et de parité (g₀, g₁) sont mappés en deux trains binaires dépendants respectivement de g₁^g₁ et g₁ avant modulation en trains d'impulsions.

### RESUME

Constatant que le codage convolutif sur le bit b à transmettre et le mappage conduisent à moduler (b.z-1^b^b.z+1, b.z-1^b.z+1, b.z-1^b.z+1), les opérations de codage et modulation peuvent être assimilées au code convolutif non systématique {3, 7, 5}, c'est-à-dire basé sur les polynômes générateurs g₀ = [111] (soit 7) et g₁ = [101] (soit 5).

Selon un aspect, il est proposé un dispositif de communication comprenant :
un récepteur configuré pour recevoir un signal formé de trains d'impulsions codant une pluralité de bits à l'aide d'un code convolutif {3, 2, 5} dont les bits systématique et de parité (g₀, g₁) sont mappés en deux trains binaires dépendants respectivement de g₀^g₁ et g₁,
un démodulateur configuré pour démoduler des paires de trains d'impulsions reçus (r₀, r₁) en des paires respectives de valeurs de bit (b₀, b₁), et
un décodeur de Viterbi construit sur un code convolutif {3, 7, 5}, configuré pour décoder chaque paire de valeurs de bit en un bit décodé.

Ainsi, le décodage ne requiert plus d'étape de mappage inverse. Les valeurs de bit en entrée du décodeur de Viterbi sont obtenues à partir des trains d'impulsions, avec la même fiabilité. Le décodage est ainsi amélioré.

Il est ainsi également proposé un système de communication comprenant un émetteur et un récepteur connecté à un même canal de communication, l'émetteur comprenant :
un codeur convolutif de code convolutif {3, 2, 5} configuré pour coder une pluralité de bits en des paires respectives de bits systématique et de parité (g₀, g₁),
un mappeur de symboles configuré pour mapper chaque paire de bits systématique et de parité (g₀, g₁) en une paire de trains binaires dépendants respectivement de g₀^g₁ et g₁,
un modulateur-émetteur configuré pour moduler et émettre chaque train binaire sous forme de train d'impulsions sur le canal de communication, et le récepteur étant un dispositif de communication tel que défini plus haut pour recevoir et décoder un signal formé desdits trains d'impulsions.

Selon un second aspect, il est proposé un procédé de communication comprenant les étapes suivantes :
recevoir un signal formé de trains d'impulsions codant une pluralité de bits à l'aide d'un code convolutif {3, 2, 5} dont les bits systématique et
de parité (g₀, g₁) sont mappés en deux trains binaires dépendants respectivement de g₀^g₁ et g₁,
démoduler des paires de trains d'impulsions reçus (r₀, r₁) en des paires respectives de valeurs de bit (b₀, b₁), et
décoder, à l'aide d'un décodeur de Viterbi construit sur un code convolutif {3, 7, 5}, chaque paire de valeurs de bit en un bit décodé.

Le procédé présente les mêmes avantages que ceux du dispositif précité.

Des caractéristiques facultatives de modes de réalisation sont définies dans les revendications annexées. Certaines de ces caractéristiques sont expliquées ci-dessous en référence à un dispositif, tandis qu'elles peuvent être transposées en caractéristiques de procédé.

Dans un mode de réalisation, les valeurs de bit comprennent des rapports de vraisemblance logarithmique (ou LLR pour « log-likelihood ratio »). Une démodulation souple (ou « soft-demodulation » est alors utilisée.

Bien entendu, une démodulation ferme (« hard demodulation ») peut être utilisée en variante.

Dans un autre mode de réalisation, la première valeur de bit d'une paire de valeurs de bit comprend un rapport de vraisemblance logarithmique associé au premier train d'impulsions d'une paire de trains d'impulsions reçus, et la deuxième valeur de bit de la paire de valeurs de bit comprend un rapport de vraisemblance logarithmique associé au deuxième train d'impulsions de la paire de trains d'impulsions reçus. Ainsi, b₀=r₀, b₁=r₁.

Le décodage souple de Viterbi peut alors être pleinement exploité. Le décodage est ainsi optimal, présentant notamment un gain évalué à 1,8 dB (en taux d'erreurs) sans complexité additionnelle.

### BREVE DESCRIPTION DES FIGURES

D'autres avantages et caractéristiques de l'invention apparaîtront à l'examen de la description détaillée de mode de réalisation et de mise en œuvre, nullement limitatifs, et des dessins annexés sur lesquels :
[Fig. 1] ;
[Fig. 2] ;
[Fig. 3];
[Fig. 4];
[Fig. 5];
[Fig. 6] ;
[Fig. 7] ; et
[Fig. 8] illustrent schématiquement des modes de mise en œuvre et de réalisation de l'invention.

### DESCRIPTION DETAILLEE

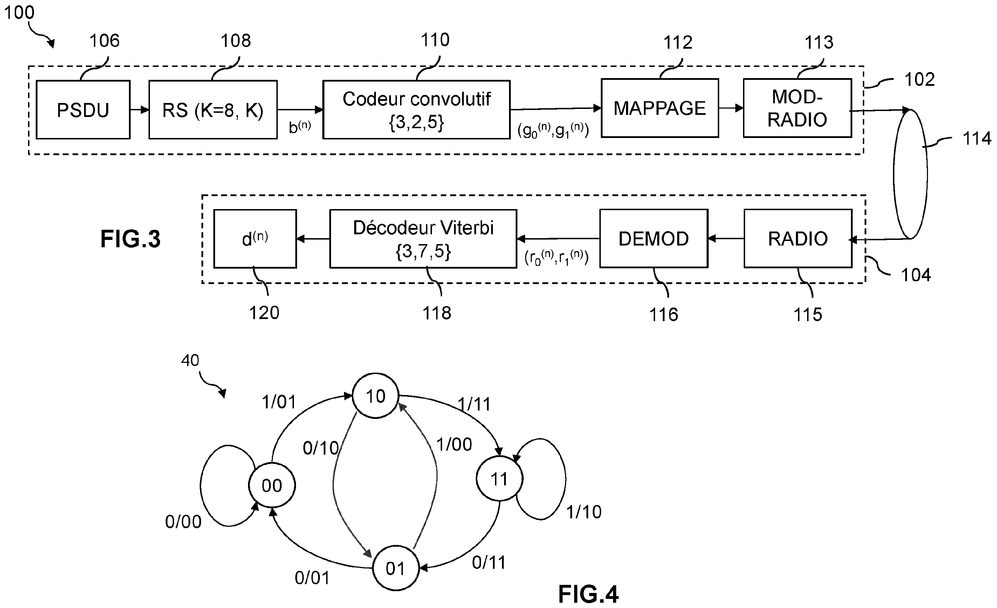

La Figure 3 représente un système de communication 100, au niveau de la couche physique PHY, comprenant un émetteur 102 et un récepteur 104. L'émetteur 102 comprend une source de données 106, typiquement d'unités de données de service PHY PSDU (pour « PHY service data unit ») reçues des couches plus hautes (non représentées) de l'émetteur 102. Un codeur Reed-Solomon 108 encode les PSDU pour introduire de la redondance.

Ces données PSDU codées et un entête PHY (noté PHR) sont alors fournies en entrée d'un codeur convolutif 110, qui produit des symboles de données. Les bits en entrée sont notés b⁽ⁿ⁾.

Le codeur convolutif 110 est systématique de type {3, 2, 5} comme représenté en Figure 1 : K=3 et les polynômes générateurs sont g₀ = [010] (soit 2) et g₁ = [101] (soit 5).

Le codeur convolutif de code convolutif {3, 2, 5} code une pluralité de bits en des paires respectives de bits systématique et de parité. En d'autres termes, chaque bit b⁽ⁿ⁾ produit un bit systématique g₀⁽ⁿ⁾ et un bit de parité g₁⁽ⁿ⁾, formant un symbole de données (g₀⁽ⁿ⁾, g₁⁽ⁿ⁾).

La Figure 4 illustre, de façon schématique, un diagramme d'état 40 du codeur convolutif 110 montrant les quatre états possibles « 00 », « 01 », « 10 » et « 11 » et les transitions possibles compte tenu d'un nouveau bit b⁽ⁿ⁾ en entrée. Par exemple, la notation 1/01 indique que la transition depuis l'état « 00 » vers l'état « 10 » est mise en œuvre lorsque le bit b⁽ⁿ⁾ en entrée vaut 1 et que la sortie du codeur convolutif 110, c'est-à-dire (g₀⁽ⁿ⁾, g₁⁽ⁿ⁾), vaut « 01 ».

Un bloc de mappage ou correspondance 112 convertit alors les symboles de données (g₀⁽ⁿ⁾, g₁⁽ⁿ⁾) en trains binaires préparant la transmission de trains d'impulsions sur un canal de transmission 114.

Chaque symbole (g₀⁽ⁿ⁾, g₁⁽ⁿ⁾) génère deux trains binaires 21, 22 (sauf pour le PHR où quatre trains sont générés) conformément aux tables 20, 20' de la Figure 2, selon le mode choisi entre le mode PRF de 124,8 MHz et le mode PRF de 249,6 MHz. A noter que si ces fréquences sont les fréquences moyennes, le mode 124,8 MHz présente une PRF de pic de 249,6 MHz pour un débit en sortie de 6,81 Mbits/s, alors que le mode 249,6 MHz présente une PRF de pic de 499,2 MHz pour un débit en sortie de 27,24 Mbits/s.

Le bloc de mappage 112 opère ainsi un mappage de symboles configuré pour mapper chaque paire de bits systématique et de parité (g0, g1) en une paire de trains binaires. Ce mappage ne réalise pas une simple correspondance entre le premier bit du symbole et le premier train binaire, et une simple correspondance entre le deuxième bit du symbole et le deuxième train binaire, mais une correspondance plus complexe. En particulier, le premier train binaire est dépendant des deux bits du symbole, notamment de g₀^g₁ (OU EXCLUSIF). Le deuxième train binaire reste fonction de g₁ seulement,

Un bloc de modulation-émission 113 module alors les trains binaires pour qu'ils soient adaptés à une transmission sur un canal de transmission 114. Une modulation BPSK (modulation par changement de phase binaire) est utilisée.

Chacun des deux (voire quatre) trains binaires 20, 21 est émis par le bloc radio 113, sur le canal de transmission 114, sous formes de train d'impulsions BPSK. Les (voire quatre) trains d'impulsions sont séparés par un intervalle de garde.

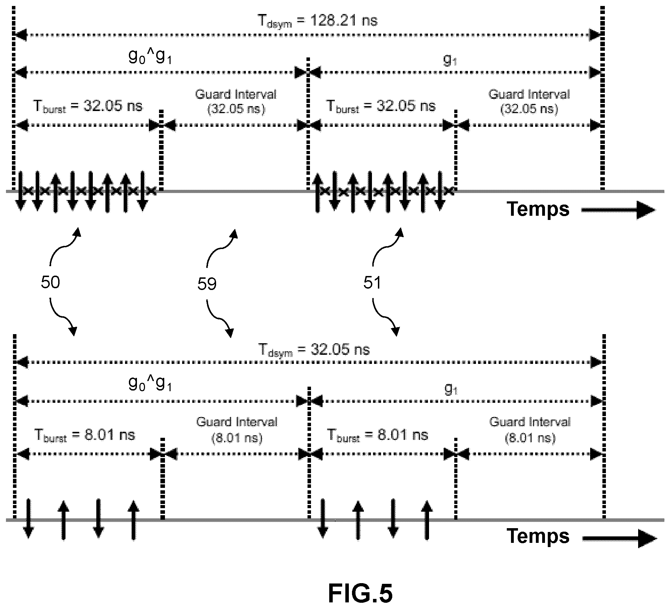

La Figure 5 illustre schématiquement les trains 50, 51 d'impulsions, séparés par un intervalle de garde 59 de même longueur, lors de la modulation d'un symbole (g₀, g₁) de PSDU dans le mode 124,8 MHz (deux trains de huit impulsions chacun, en haut) et dans le mode 249,6 MHz (deux trains de quatre impulsions chacun, en bas).

Le canal de transmission 114 est par exemple un canal sans fil dans la bande de fréquences comprises entre 3.1GHz et 10,6GHz, préférentiellement dans la bande 3.1GHz-4.8GHz ou la bande 6GHz-8,5GHz. Le canal de transmission 114 est typiquement défini avec une bande passante de 499,2MHz, 500MHz ou supérieure.

Le récepteur 104 comprend un bloc démodulateur 116, qui reçoit le signal du canal 114, par exemple via un récepteur Rake 115, et démodule (BPSK) le signal pour récupérer les trains binaires transmis et déterminer des valeurs de confiance ou « de rapport de vraisemblance logarithmique » (LLR) correspondant aux symboles de données reçus, notés o⁽ⁿ⁾, ici une paire de trains d'impulsions reçus. On note r₀⁽ⁿ⁾ et r₁⁽ⁿ⁾ les deux trains binaires pour chaque paire o⁽ⁿ⁾ de trains d'impulsions reçus. Par simplicité, on note également r₀⁽ⁿ⁾ et r₁⁽ⁿ⁾ (et plus généralement r₀ et r₁) les valeurs LLRs associées. Aussi, o⁽ⁿ⁾=(r₀⁽ⁿ⁾, r₁⁽ⁿ⁾).

Dans un mode de réalisation alternatif, le bloc démodulateur 116 fournit des bits fermes (soit 0, soit 1) plutôt que des valeurs LLR.

Par la suite, l'indice n peut être omis par simplicité lorsqu'il s'agit du traitement d'un symbole o=(r₀, r₁).

Les symboles reçus o⁽ⁿ⁾, c'est-à-dire les valeurs LLR r₀⁽ⁿ⁾ et r₁⁽ⁿ⁾, sont successivement fournis à un décodeur de canal 118 qui réalise un décodage de canal, dans cet exemple en utilisant un décodeur à algorithme de Viterbi à entrée pondérée (décodeur SIVA - « soft-input Viterbi algorithm ») pour récupérer les données codées initiales b⁽ⁿ⁾.

Les entrées du décodeur de Viterbi sont notées b₁ et b₁. b₀=r₀ et b₁=r₁ signifiant qu'il n'y a aucun prétraitement des LLRs obtenues du bloc démodulateur 116, notamment de mappage inverse de celui réalisé par le bloc modulateur 112 sur la base des tables 20, 20' de la Figure 2.

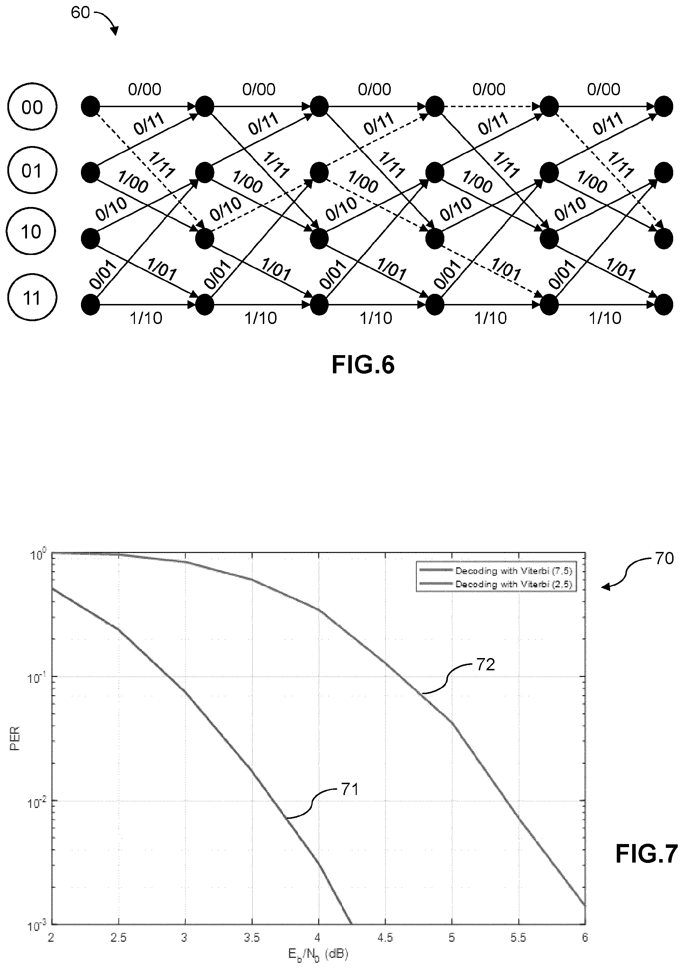

La Figure 6 représente un diagramme de treillis 60 correspondant aux symboles de décodage initialement codés par une machine à états finis différente de celle de la Figure 1 (et donc de l'émetteur 102). Compte tenu de ce que le codage convolutif sur un bit b à transmettre et le mappage de la Figure 2 conduisent à moduler (b.z-1^b^b.z+1, b.z-1^b.z+1, b.z-1^b.z+1), ces opérations de codage et modulation sont considérées, de façon unitaire, par le récepteur 104 : elles correspondent alors à un codage convolutif non systématique {3, 7, 5}, c'est-à-dire basé sur les polynômes générateurs g₀ = [111] (soit 7) et g₁ = [101] (soit 5).

Aussi, le diagramme de treillis 60 de la Figure 6 est celui d'une machine à états finis correspondant au codeur convolutif non systématique {3, 7, 5}. Les quatre états « 00 », « 01 », « 10 » et « 11 » sont représentés dans chacune des six colonnes, munis de flèches d'interconnexions pour représenter tous les trajets possibles entre états pendant cinq transitions d'états successives correspondant à cinq symboles o⁽ⁿ⁻⁴⁾ à o⁽ⁿ⁾ obtenus. Dans cet exemple, pour chacun des quatre états, il y a un choix de deux états suivants distincts. Comme cela est représenté pour la transition à partir de la colonne de gauche des états vers la colonne adjacente des états, chaque transition d'état correspond à un symbole reçu différent.

Les lignes en pointillés de la figure représentent, à titre purement illustratif, les transitions d'états les plus probables, en conservant un chemin par état, et montrent qu'après un certain nombre L de transitions, dans cet exemple cinq transitions, les trajets probables se confondent en un seul trajet. En utilisant ce principe, les bits de données b⁽ⁿ⁾ peuvent être décodés avec un retard de L périodes de symboles.

Les bits 120 décodés de la sorte sont notés d⁽ⁿ⁾ sur la figure.

La Figure 7 illustre, à l'aide d'un graphique 70, le gain de 1,8 dB obtenu par l'utilisation d'un décodeur de Viterbi construit sur un code convolutif {3, 7, 5} (courbe 71), plutôt que l'approche classique de mappage inverse de la Figure 2 pour récupérer g₀ et g₁ puis d'utilisation d'un décodeur de Viterbi construit sur le code convolutif d'encodage, à savoir {3, 2, 5} (courbe 72). Ce gain est en outre assorti d'une simplification de la complexité (absence du mappage inverse) sans coût calculatoire additionnel (usage similaire d'un décodeur de Viterbi).

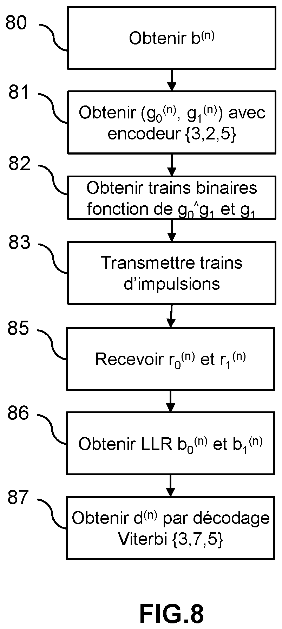

Enfin, la Figure 8 illustre, à l'aide d'un ordinogramme, des étapes d'un procédé de communication.

A l'étape 80, l'émetteur 102 obtient des bits b⁽ⁿ⁾ à transmettre, préférentiellement les données PSDU codées par un codeur Reed-Solomon et l'entête PHR.

A l'étape 81, les bits sont encodés par le codeur convolutif 110 de type {3, 2, 5} pour obtenir (g₀⁽ⁿ⁾, g₁⁽ⁿ⁾).

A l'étape 82, des trains binaires sont obtenus à partir de (g₀⁽ⁿ⁾, g₁⁽ⁿ⁾) en utilisant l'une des tables de la Figure 2.

A l'étape 83, les trains binaires sont transmis sous forme de trains d'impulsions en utilisant une modulation BPSK.

La suite du procédé prend place du côté du récepteur 104.

A l'étape 85, le récepteur 104 reçoit les trains d'impulsions r₀⁽ⁿ⁾ et r₁⁽ⁿ⁾.

A l'étape 86, des valeurs b₀⁽ⁿ⁾ et b₁⁽ⁿ⁾ de rapport de vraisemblance logarithmique LLR sont obtenus pour les trains d'impulsions.

A l'étape 87, ces valeurs b₀⁽ⁿ⁾ et b₁⁽ⁿ⁾ sont décodées par un décodeur de Viterbi construit sur un codage convolutif non systématique {3, 7, 5}, de sorte à obtenir les bits décodés d⁽ⁿ⁾ correspondant aux bits de données initiaux b⁽ⁿ⁾.

Les données b⁽ⁿ⁾ transmises peuvent être utilisées dans le cadre d'opérations de contrôle d'accès (à un bâtiment, véhicule, système informatique, etc.), d'opérations de localisation, mais également d'opérations de commande d'équipements (typiquement domotique).

## Revendications

1. Dispositif de communication (100) comprenant :
un récepteur (115) configuré pour recevoir un signal formé de trains d'impulsions (r₀, r₁) codant une pluralité de bits (b) à l'aide d'un code convolutif {3, 2, 5} dont les bits systématique g₀ et de parité g₁ sont mappés en deux trains binaires (21, 22) dépendants respectivement de g₀^g₁ et g₁,
un démodulateur (116) configuré pour démoduler des paires de trains d'impulsions reçus (r₀, r₁) en des paires respectives de valeurs de bit (b₀, b₁), et
un décodeur de Viterbi (118) construit sur un code convolutif {3, 7, 5}, configuré pour décoder chaque paire de valeurs de bit en un bit décodé (d).

2. Dispositif de communication (100) selon la revendication 1, dans lequel les valeurs de bit (b₀, b₁) comprennent des rapports de vraisemblance logarithmique.

3. Dispositif de communication (100) selon la revendication 1 ou 2, la première valeur de bit (b₀) d'une paire de valeurs de bit comprend un rapport de vraisemblance logarithmique associé au premier train d'impulsions (r₀) d'une paire de trains d'impulsions reçus, et la deuxième valeur de bit (b₁) de la paire de valeurs de bit comprend un rapport de vraisemblance logarithmique associé au deuxième train d'impulsions (r₁) de la paire de trains d'impulsions reçus.

4. Système de communication (100) comprenant un émetteur (102) et un récepteur (104) connecté à un même canal de communication (114), l'émetteur (102) comprenant :
un codeur convolutif (110) de code convolutif {3, 2, 5} configuré pour coder une pluralité de bits (b) en des paires respectives de bits systématique g₀ et de parité g₁,
un mappeur de symboles (112) configuré pour mapper chaque paire de bits systématique g₀ et de parité g₁ en une paire de trains binaires dépendants respectivement de g₀^g₁ et g₁,
un modulateur-émetteur (113) configuré pour moduler et émettre chaque train binaire sous forme de train d'impulsions sur le canal de communication (144),
et le récepteur (104) étant un dispositif de communication selon l'une des revendications 1 à 3, pour recevoir et décoder un signal formé desdits trains d'impulsions.

5. Procédé de communication comprenant les étapes suivantes :
recevoir (85) un signal formé de trains d'impulsions (r₀, r₁) codant une pluralité de bits à l'aide d'un code convolutif {3, 2, 5} dont les bits systématique g₀ et de parité g₁ sont mappés en deux trains binaires dépendants respectivement de g₀^g₁ et g₁,
démoduler des paires de trains d'impulsions reçus (r₀, r₁) en des paires respectives de valeurs de bit (b₀, b₁), et
décoder, à l'aide d'un décodeur de Viterbi construit sur un code convolutif {3, 7, 5}, chaque paire de valeurs de bit en un bit décodé (d).
